# FASCICULE DE BREVET EUROPEEN

(11) **EP 2 689 532 B1**
(45) Date de publication et mention de la délivrance du brevet: **21.01.2015**
(21) Numéro de dépôt: 12708030.7
(22) Date de dépôt: 12.03.2012
(51) Int. Cl.: H03K 17/96, G01L 1/20

(54) **PANNEAU DE COMMANDE À TOUCHES RÉSISTIVES ET ENTRETOISES**
BEDIENFELD MIT RESISTIVEN SCHALTFLÄCHEN UND ABSTANDHALTERN
CONTROL PANEL COMPRISING RESISTIVE BUTTONS AND SPACERS

(30) Priorité: 21.03.2011 FR 1152302
(43) Date de publication de la demande: 29.01.2014
(73) Titulaire: Delphi Technologies, Inc., Troy, MI 48007 (US)
(72) Inventeur: AUBERGER, Stéphane, F-67100 Strasbourg (FR); LOBSTEIN, Roland, F-67400 Illkirch (FR)
(74) Mandataire: Robert, Vincent
(86) Numéro de dépôt international: PCT/EP2012/054214
(87) Numéro de publication internationale: WO 2012/126754

(56) Documents cités:
- EP-A1- 0 489 344
- WO-A1-2009/070503
- GB-A- 2 180 994
- US-A- 4 555 954
- US-A1- 2002 000 979
- US-A1- 2003 107 556
- US-A1- 2006 007 172
- US-A1- 2006 066 589

## Description

### DOMAINE TECHNIQUE

La présente invention concerne un panneau de commande, notamment pour un véhicule automobile, comportant des touches résistives.

### ARRIERE-PLAN TECHNOLOGIQUE DE L'INVENTION

La présente invention concerne plus particulièrement un panneau de commande destiné à être agencé dans l'habitacle d'un véhicule automobile, notamment au tableau de bord, et qui comporte au moins un bouton de commande sous la forme d'une touche résistive prévu pour commander une fonction déterminée, par exemple pour commander la mise en marche ou l'arrêt de la fonction air conditionné.

Le panneau de commande comporte un capot qui est monté sur un support et qui est muni d'au moins une zone de détection prévue pour former un bouton de commande. Un capteur d'effort est agencé entre le capot et le support, à l'arrière de la zone de détection, de manière à produire un signal électrique de commande lorsqu'un utilisateur exerce une force d'appui suffisante sur la zone de détection.

Pour compenser les jeux mécaniques entre le capteur d'effort et la zone de détection, il est connu d'agencer une entretoise, sous la forme d'une plaquette en matériau élastomère, entre le capteur d'effort et le capot pour permettre d'assurer en toute circonstance une transmission directe de la force d'appui tactile vers le capteur d'effort par l'intermédiaire de l'entretoise. A cet effet, l'entretoise est montée comprimée axialement entre le capteur d'effort et le capot. EP0489344 décrit un panneau de commande selon l'état de la technique.

Pour permettre la détection de l'appui tactile, il est nécessaire que l'épaisseur du capot dans la zone de détection soit relativement faible de manière à permettre une légère déformation élastique du capot vers le capteur lors de l'appui tactile. Or, le montage de l'entretoise en compression entre le capteur et le capot tend à provoquer une déformation du capot vers l'extérieur au niveau de l'entretoise ce qui dégrade l'aspect extérieur du capot. De plus, la répartition de la pression sur l'entretoise n'est pas homogène, l'appui principal se faisant généralement sur le bord périphérique extérieur de l'entretoise.

Ces inconvénients sont particulièrement pénalisants dans des applications soumises à de grandes variations de température, comme dans un véhicule automobile, ce qui peut conduire à une perte de la pression sur l'entretoise.

### RESUME DE L'INVENTION

La présente invention vise à remédier aux inconvénients mentionnés précédemment en proposant une solution simple, efficace, et économique.

Dans ce but, l'invention propose panneau de commande, notamment pour un véhicule automobile, comportant un capot qui est monté sur un support et qui est muni d'au moins une zone de détection d'un appui tactile formant bouton de commande, dans lequel un capteur d'effort comportant une zone sensible à la pression est agencé entre le capot et le support, à l'arrière de la zone de détection, de manière à détecter l'actionnement du bouton de commande pour produire un signal électrique de commande lorsqu'un utilisateur exerce une force d'appui tactile déterminée sur la zone de détection, la force d'appui tactile étant transmise axialement vers la zone sensible par l'intermédiaire d'une entretoise en matériau compressible élastiquement qui est intercalée entre le capteur et le capot, caractérisé en ce que l'entretoise est montée comprimée axialement entre le capteur et le capot en l'absence d'appui tactile sur la zone de détection de manière que le capteur subisse une force de précontrainte au repos l'entretoise comportant au moins un plot intercalaire pourvu d'une surface sommitale transversale qui est en appui contre le capot et d'une surface de base transversale qui est en appui contre la zone sensible du capteur, la surface sommitale ayant une aire inférieure à l'aire de la surface de base de manière à minimiser la force de réaction exercée par l'entretoise sur le capot tout en assurant une répartition homogène de la force de précontrainte et de la force d'appui tactile sur la zone sensible du capteur.

Grâce à l'invention, la surface de contact entre l'entretoise et le capot est minimisée ce qui permet de diminuer les contraintes appliquées sur le capot. L'invention permet d'appliquer une force de précontrainte sur le capteur qui est inférieure à la force de précontrainte appliquée sur le capteur par une entretoise conventionnelle en forme de pavé parallélépipédique d'épaisseur axiale constante, tout en garantissant qu'il y ait toujours une force de précontrainte minimale malgré les tolérances de fabrication, de montage, et malgré les variations de température.

En minimisant l'intensité de la force de précontrainte nominale, l'invention permet de réduire les risques de fluage dus à des forces d'appui trop élevées au niveau du capteur et au niveau du capot. De plus, plus l'intensité de la force de précontrainte est faible, plus la détection de l'activation du bouton de commande associé est facile.

Selon d'autres caractéristiques avantageuses :
- la zone de détection comporte une zone rétro-éclairée qui est prévue pour être rétro-éclairée à travers l'entretoise, et l'entretoise comporte un évidement central pour le passage axial de la lumière vers la zone d'illumination ;
- l'évidement central correspond à un trou traversant aménagé dans l'entretoise ;
- l'entretoise comporte au moins un passage transversal qui fait communiquer l'intérieur de l'évidement central avec l'extérieur de l'entretoise ;
- la zone sensible a globalement une forme annulaire qui délimite un espace central dont la forme correspond globalement à la forme de l'évidement central en vue de faciliter le passage de la lumière à travers le capteur d'effort ;
- l'entretoise comporte un seul plot intercalaire de forme globalement tronconique ;
- l'entretoise comporte plusieurs plots intercalaires ;
- les plots intercalaires sont répartis sensiblement parallèlement au contour extérieur de la zone sensible du capteur ;
- la zone sensible a globalement un contour extérieur rectangulaire et l'entretoise comporte, en vis-à-vis de la zone sensible, deux plots intercalaires qui s'étendent dans la longueur de la zone sensible et deux plots intercalaires qui s'étendent dans la largeur de la zone sensible ;
- chaque plot intercalaire a globalement la forme d'une pyramide tronquée et allongée comportant des faces latérales trapézoïdales et une surface sommitale globalement rectangulaire ;
- les plots intercalaires associés à une zone sensible déterminée possèdent des épaisseurs axiales distinctes adaptées aux variations de hauteur du capot par rapport au capteur ;
- l'entretoise et le capteur sont montés comprimés axialement entre le capot et une platine intermédiaire qui est fixée directement sur le capot, indépendamment du support ;
- l'entretoise est réalisée venue de matière avec une plaque d'entretoise transversale et la plaque d'entretoise est pourvue de moyens de positionnement qui assurent le centrage de l'entretoise vis-à-vis de la zone sensible et vis-à-vis de la zone de détection associées ;
- la plaque d'entretoise comporte plusieurs entretoises qui sont associées respectivement à plusieurs zones de détection.
- une plaquette en matériau plus rigide que le matériau constituant l'entretoise est intercalée entre l'entretoise et la zone sensible du capteur en vue de contribuer à une répartition homogène de la force de précontrainte et de la force d'appui tactile sur la zone sensible du capteur.

### BREVE DESCRIPTION DES DESSINS

D'autres caractéristiques, buts et avantages de l'invention apparaîtront à la lecture de la description détaillée qui va suivre, et en regard des dessins annexés, donnés à titre d'exemple non limitatif et sur lesquels:
- la figure 1 est une vue éclatée en perspective qui représente schématiquement un panneau de commande équipé de touches résistives munies de capteurs d'effort et d'entretoises selon un premier mode de réalisation de l'invention dans lequel chaque entretoise est constituée d'un plot intercalaire tronconique ;
- la figure 2 est une vue partielle en coupe axiale selon le plan 2-2 qui représente schématiquement la structure d'un capteur d'effort et d'une entretoise équipant le panneau de commande de la figure 1 ;
- la figure 3 est une vue de dessus qui représente schématiquement un film portant plusieurs capteurs d'efforts prévu équiper le panneau de commande de la figure 1 ;
- la figure 4 est une vue en perspective qui représente schématiquement une plaque d'entretoise portant plusieurs entretoises et équipant le panneau de commande de la figure 1 ;
- la figure 5 est une vue en perspective et en coupe axiale selon le plan 5-5 qui représente une partie du panneau de commande de la figure 1 ;
- la figure 6 est une vue en perspective qui représente un panneau de commande réalisé selon un deuxième mode de réalisation de l'invention ;
- la figure 7 est une vue en perspective qui représente la plaque d'entretoise équipant le panneau de commande de la figure 6 ;
- la figure 8 est une vue de côté selon la flèche F8 qui représente la plaque d'entretoises de la figure 7 ;
- la figure 9 est une vue similaire à celle de la figure 7 qui représente une plaque d'entretoise correspondant à un troisième mode de réalisation de l'invention dans lequel chaque entretoise est munie de plusieurs plots intercalaires d'épaisseurs axiales différentes ;
- la figure 10 est une vue de côté selon la flèche F10 qui représente la plaque d'entretoise de la figure 9.

### DESCRIPTION DES MODES DE REALISATION PREFERES

Dans la suite de la description, des éléments identiques ou similaires pourront être désignés par des références identiques.

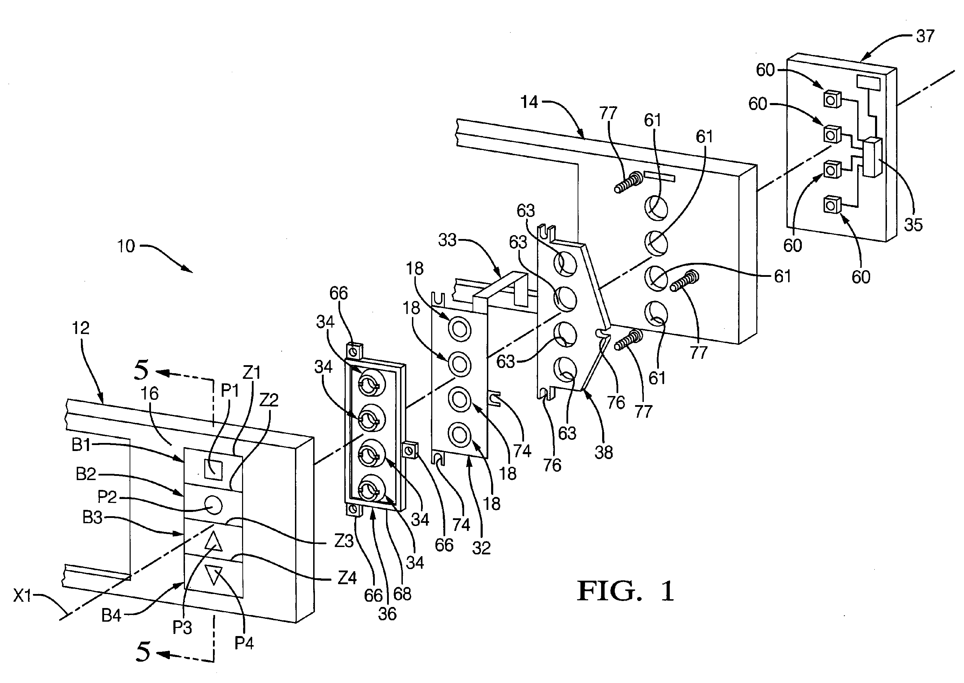

Sur la figure 1, on a représenté un panneau de commande 10 pour un tableau de bord de véhicule automobile réalisé selon un premier mode de réalisation conforme aux enseignements de l'invention. Il comporte ici un capot 12 qui est monté sur un support 14, la surface extérieure 16 du capot 12 comportant plusieurs zones de détection Z1, Z2, Z3, Z4 d'un appui tactile formant plusieurs boutons de commande B1, B2, B3, B4, ou touches résistives. Selon l'exemple représenté ici, les touches résistives sont au nombre de quatre. De préférence, chaque bouton de commande B1, B2, B3, B4 est pourvu d'un pictogramme P1, P2, P3, P4 qui est prévu pour être rétro-éclairé. Les pictogrammes P1, P2, P3, P4 sont réalisés par exemple par grattage au laser sur la face extérieure 16 du capot 12 et forment ainsi des zones de rétro-éclairage.

Dans la suite de la description, on utilisera à titre non limitatif une orientation axiale suivant un axe X1 sensiblement orthogonal au plan général du capot 12, orienté de l'avant vers l'arrière, c'est-à-dire depuis le capot 12 vers le support 14, ce qui correspond globalement à une orientation de la gauche vers la droite en considérant la figure 1.

Chaque bouton de commande B1, B2, B3, B4 comporte ici un capteur d'effort 18 qui est agencé entre le capot 12 et le support 14, à l'arrière et axialement en vis-à-vis de la zone de détection Z1, Z2, Z3, Z4 associée. Chaque capteur d'effort 18 est prévu pour détecter l'actionnement du bouton de commande B1, B2, B3, B4 associé et produire un signal électrique de commande lorsqu'un utilisateur exerce une force d'appui tactile d'intensité suffisante sur la zone de détection Z1, Z2, Z3, Z4 associée.

Selon une caractéristique avantageuse de l'invention, chaque capteur d'effort 18 est du type à résistance variable en fonction de l'effort, par exemple du type FSR (Force Sensing Resistor) comme décrit et représenté dans les documents US2006/0007172A1 et WO2009/070503A1.

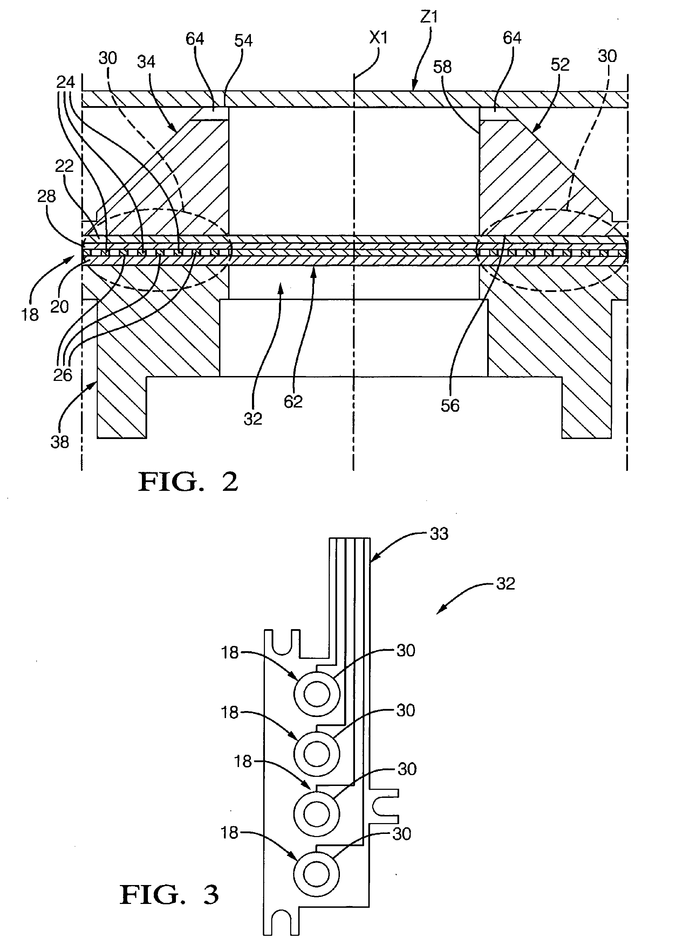

De préférence, on utilise ici un capteur d'effort 18 monté sous précontrainte mécanique, comme on l'a représenté sur les figures 2 et 3. Le capteur d'effort 18 comporte ici un premier 20 et un second 22 substrats dont l'un au moins est flexible lorsqu'une force d'appui tactile est exercée sur la zone de détection Z1 associée. Des pistes conductrices électriques 24, 26 sont agencées, par exemple sous la forme de peignes interdigités, sur une face du premier substrat 20 en vis-à-vis d'un revêtement résistif 28 agencé sur la face en vis-à-vis du second substrat 22, de manière à définir une zone sensible à la pression 30, ici de forme annulaire, qui est globalement en vis-à-vis de la zone de détection Z1 associée. A l'état de repos du capteur d'effort 18, en l'absence de force d'appui tactile, le revêtement résistif 28 est en contact électrique avec des portions de pistes conductrices 24, 26.

Selon l'exemple représenté, les quatre boutons de commande B1, B2, B3, B4, B5, B6 étant positionnés de manière sensiblement adjacente sur le capot 12, il est possible d'agencer les quatre capteurs d'effort 18 associés sur les mêmes substrats 20, 22. Ainsi, comme représenté sur les figures 1 et 3, les capteurs d'effort 18 se présentent sous la forme d'un film 32 comportant une nappe 33 de raccordement électrique prévue pour permettre le raccordement des quatre capteurs 18 à une unité électronique de commande 35 agencée sur une plaque à circuit imprimé 37, à l'arrière du support 14.

Selon le mode de réalisation représenté, une entretoise 34 en matériau compressible élastiquement est montée entre chaque capteur 18 et le capot 12, en vis-à-vis de la zone de détection Z1, Z2, Z3, Z4 de manière à rattraper les jeux mécaniques entre le capteur 18 et le capot 12. De préférence, les quatre entretoises 34 prévues pour les quatre capteurs 18 sont toutes formées par moulage dans une plaque d'entretoise 36 en matériau élastomère du type silicone.

On note que, du fait de la rigidité relative du capot 12 au niveau de la zone de détection Z1, Z2, Z3, Z4, les jeux de fonctionnement, c'est-à-dire les déplacements axiaux X1 du capot 12 au niveau de la zone de détection, peuvent être inférieurs aux jeux mécaniques: Les entretoises 34 permettent donc de rattraper les jeux mécaniques pour permettre la détection des déplacements axiaux X1 du capot 12 dus à des appuis tactiles.

De préférence, l'épaisseur de la paroi du capot 12 est amincie dans les zones de détection Z1, Z2, Z3, Z4 de manière à rendre cette paroi plus facilement déformable lors d'un appui tactile, la déformation devant être suffisante pour permettre une détection de cet appui par le capteur 18 correspondant.

Selon le mode de réalisation représenté, une platine intermédiaire 38 est agencée entre le support 14 et le film 32 portant les capteurs d'effort 18, et elle est fixée directement à l'arrière du capot 16, indépendamment du support 14. Plus précisément, la plaque d'entretoise 36 et le film 32 sont montés comprimés axialement entre le capot 16 et la platine intermédiaire 38 pour permettre le montage des capteurs d'effort 18 sous précontrainte, c'est-à-dire pour que les capteurs d'efforts 38 soient montés, au repos, comprimés axialement.

La platine intermédiaire 38 est fixée à l'arrière du capot 16, par exemple au moyen de vis, ce qui permet d'ajuster l'intensité de la force de précontrainte appliquée sur les capteurs d'effort 18 indépendamment des contraintes de montage du capot 16 sur le support 14, et indépendamment des solutions de fixation du capot 16 sur le support 14, la platine intermédiaire 38 étant pré-assemblée sur le capot 16.

Le fait de pré-contraindre les capteurs d'effort 18 au moyen d'une platine intermédiaire distincte du support 14 permet d'optimiser les caractéristiques structurelles de la platine intermédiaire 38 de manière qu'elle remplisse au mieux sa fonction de contre-appui, notamment en choisissant une méthode de fabrication, un matériau de fabrication, une géométrie particulièrement adaptés à cette fonction. Cela permet en particulier d'appliquer des contraintes de fabrication plus sévères, ou différentes, à cette platine intermédiaire sans qu'il soit nécessaire d'appliquer les mêmes contraintes de fabrication au support 14.

La platine intermédiaire 38 est prévue pour offrir une grande rigidité par rapport aux zones de détection Z1, Z2, Z3, Z4 de la paroi du capot 16. Elle est avantageusement moulée par injection en polymère thermoplastique chargé en fibre de verre de manière à obtenir une rigidité suffisante pour la fonction de contre-appui tout en s'assurant de faibles tolérances de fabrication et d'une bonne planéité de la surface d'appui prévue pour être en contact avec les capteurs d'effort 18. La platine intermédiaire 38 est réalisée par exemple en Polybutylène Téréphtalate (PBT) chargé en fibre de verre à 30%.

Avantageusement, chaque entretoise 34 comporte, en vis-à-vis de la zone de détection Z1, Z2, Z3, Z4 associée du capot 12, au moins un plot intercalaire 52 qui est pourvu d'une surface sommitale 54 à l'avant et d'une surface de base 56 à l'arrière. La surface sommitale 54 s'étend ici dans un plan globalement transversal, parallèlement à la face arrière de la zone de détection Z1, Z2, Z3, Z4 associée contre laquelle elle vient en appui axial. La surface de base 56 s'étend aussi dans un plan globalement transversal, parallèlement au plan du film 32 portant les capteurs d'effort 18. La surface sommitale 54 possède une aire inférieure à l'aire de la surface de base 56 de manière à minimiser la force de réaction exercée par l'entretoise 34 sur le capot 12 tout en assurant une répartition homogène de la force de précontrainte et de la force d'appui tactile sur la zone sensible 30 du capteur 18.

Selon le premier mode de réalisation représenté sur les figures 1 à 5, chaque entretoise 34 est constituée ici par un plot intercalaire 52 unique en forme de tronc de cône. Ce plot intercalaire 52 comporte un évidement central 58 cylindrique, ou alésage, qui débouche à chaque extrémité axiale et qui vise à permettre le passage d'un faisceau lumineux de rétro-éclairage produit par une source lumineuse 60 agencée en vis-à-vis du pictogramme P1, P2, P3, P4 à rétro-éclairer. Chaque source lumineuse 60 est constituée ici par une diode électroluminescente agencée sur la plaque à circuit imprimé 37, axialement en vis-à-vis du pictogramme P1, P2, P3, P4 associé.

Selon le mode de réalisation représenté, des ouvertures 61, 63 correspondantes sont pratiquées dans l'épaisseur du support 14 et dans l'épaisseur de la platine intermédiaire 38, en vis-à-vis de chaque évidement 58 et de chaque source lumineuse 60, pour permettre le passage de la lumière à travers le support 14 et à travers la platine intermédiaire 38, vers le pictogramme P1, P2, P3, P4 associé.

Selon une variante de réalisation (non représentée), un ou plusieurs guides de lumière peuvent être utilisés pour transmettre la lumière émise par une ou plusieurs diodes électroluminescentes vers les pictogrammes P1, P2, P3, P4.

Les diamètres externe et interne de la surface de base 56 de chaque plot intercalaire 52 sont sensiblement identiques aux diamètres externe et interne de la zone sensible 30 annulaire associée de manière que la surface de base 56 se superpose avec ladite zone sensible 30.

On note que le film 32 portant les capteurs d'effort 18 est ici translucide de sorte que la partie centrale 62 de la zone sensible 30 annulaire laisse passer une quantité suffisante de lumière pour permettre le rétro-éclairage du pictogramme P1, P2, P3, P4 associé axialement à travers le film 32.

Selon des variantes de réalisation (non représentées), seule la partie centrale 62 pourrait être translucide ou la partie central 62 pourrait être évidée en vue de laisser passer la lumière axialement.

Selon une caractéristique avantageuse, chaque entretoise 34 comporte au moins un passage transversal 64 permettant de faire communiquer l'intérieur de l'évidement central 58 avec l'extérieur du plot intercalaire 52. Selon le mode de réalisation représenté, chaque plot intercalaire 52 comporte deux rainures diamétralement opposées qui sont réalisées dans la surface sommitale 54. Ces passages transversaux 64 visent à éviter un « effet ventouse », c'est-à-dire la création d'une bulle d'air entre le capot 12 et le film 32 lors du montage en compression axiale du plot intercalaire 52.

Selon le mode de réalisation représenté, la plaque d'entretoise 36 est pourvue de moyens de positionnement 66, 68 qui visent à assurer le centrage de la plaque d'entretoise 36 par rapport au capot 12 et en particulier le centrage de chaque entretoise 34 vis-à-vis de la zone sensible Z1, Z2, Z3, Z4 associée. Les moyens de positionnement 66, 68 comportent ici des oreilles 66 munies de perçages qui coopèrent avec des fûts de vissage 70 agencés à l'arrière du capot 12. Les moyens de positionnement 68 comportent aussi un rebord périphérique 68, en saillie vers l'avant, qui s'étend le long du bord périphérique extérieur de la plaque d'entretoise 36 et qui coopère avec une surface complémentaire de centrage 72 aménagée dans la face arrière du capot 12. Le rebord périphérique 68 permet aussi de rigidifier la plaque d'entretoise 36 pour faciliter sa manipulation lors des opérations d'assemblage.

Avantageusement, le film 32 et la platine intermédiaire 38 comportent aussi des oreilles percées 74, 76 prévues pour être coopérer avec les fûts de vissage 70 en vue de permettre leur centrage par rapport au capot 12.

Des vis de fixation 77 adaptées aux fûts de vissage 70 sont ici prévues pour la fixation de la platine intermédiaire 38 contre le capot 12.

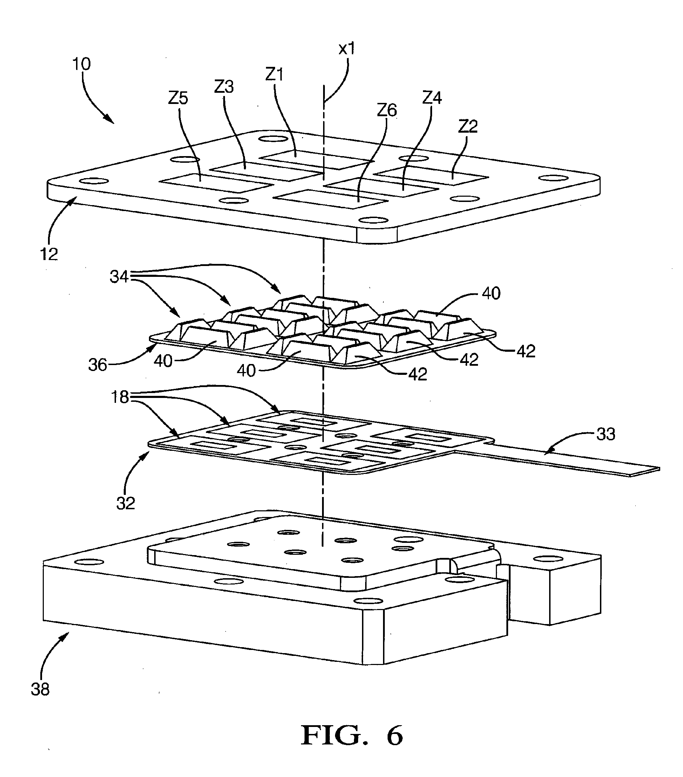

Un deuxième mode de réalisation du panneau de commande 10 selon l'invention va maintenant être décrit en référence aux figures 6 à 8 où l'on a représenté schématiquement un panneau de commande 10 simplifié de forme globalement parallélépipédique. Ce deuxième mode de réalisation est ici dépourvu de dispositif de rétro-éclairage. Bien entendu, ce panneau de commande 10 pourrait revêtir d'autres formes adaptées à son agencement dans l'habitacle d'un véhicule et il pourrait être muni d'un dispositif de rétro-éclairage.

Dans l'exemple de réalisation représenté, le panneau de commande 10 comporte ici six zones de détection Z1, Z2, Z3, Z4, Z5, Z6 et donc six entretoises 34 associées sur la plaque d'entretoise 36. Les zones de détection Z1, Z2, Z3, Z4, Z5, Z6 sont ici toutes identiques et de formes rectangulaires.

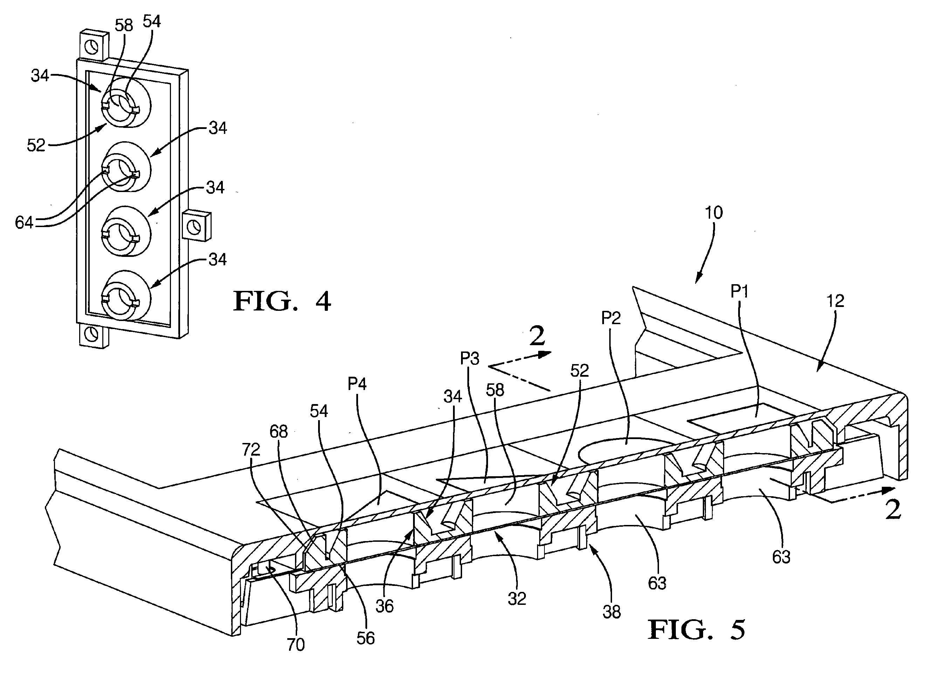

Dans le cadre du deuxième mode de réalisation représenté sur les figures 4 à 6, chaque entretoise 34 comporte plusieurs plots intercalaires 40, 42. Ces plots intercalaires 40, 42 ont ici chacun une forme pyramidale tronquée allongée parallèlement au plan du capot 12. Plus précisément, chaque plot intercalaire 40, 42 possède ici deux faces latérales 46 sensiblement trapézoïdales et deux faces d'extrémité 48 sensiblement trapézoïdales qui se rejoignent au sommet pour former la surface sommitale 44 qui est sensiblement rectangulaire et prévue pour être en appui contre le capot 12.

Avantageusement, les plots intercalaires 40, 42 sont répartis sensiblement parallèlement au bord périphérique externe de la zone sensible 30 associée du capteur 18. Ici, chaque zone sensible 30 a globalement un contour extérieur rectangulaire et l'entretoise 34 comporte, en vis-à-vis de la zone sensible 30, deux plots intercalaires longitudinaux 40 qui s'étendent dans la longueur de la zone sensible 30 et deux plots intercalaires transversaux 42 qui s'étendent dans la largeur de la zone sensible 30. Les plots intercalaires 40, 42 sont ici contigus, chaque bord d'extrémité longitudinale de chaque plot intercalaire longitudinal 40 étant adjacent à un bord transversal d'un plot intercalaire transversal 42.

On note que les plots intercalaires 40, 42 d'une entretoise 34 déterminée ne sont pas contigus au niveau de leurs surfaces sommitales 44, en contact avec le capot 12, de sorte que des passages transversaux 54 sont ménagés entre ces différentes surfaces sommitales 44. Ces passages transversaux 54 permettent notamment d'éviter la création d'une bulle d'air au montage, entre l'entretoise 34 et le capot 12.

Grâce à la structure particulière des entretoises 34 selon l'invention, la surface d'appui du capot 12 sur les entretoises 34 est minimisée puisqu'elle est limitée aux surfaces sommitales 44 des plots intercalaires 40, 42, 52. De part la forme de chaque plot intercalaire 40, 42, 52 qui s'élargit jusqu'à sa base, c'est-à-dire vers la zone sensible 30 du capteur 18, la force de précontrainte et d'appui axial qui est appliquée par le capot 12 sur la surface sommitale 44 se répartit sur une surface plus étendue au niveau de la zone sensible 30.

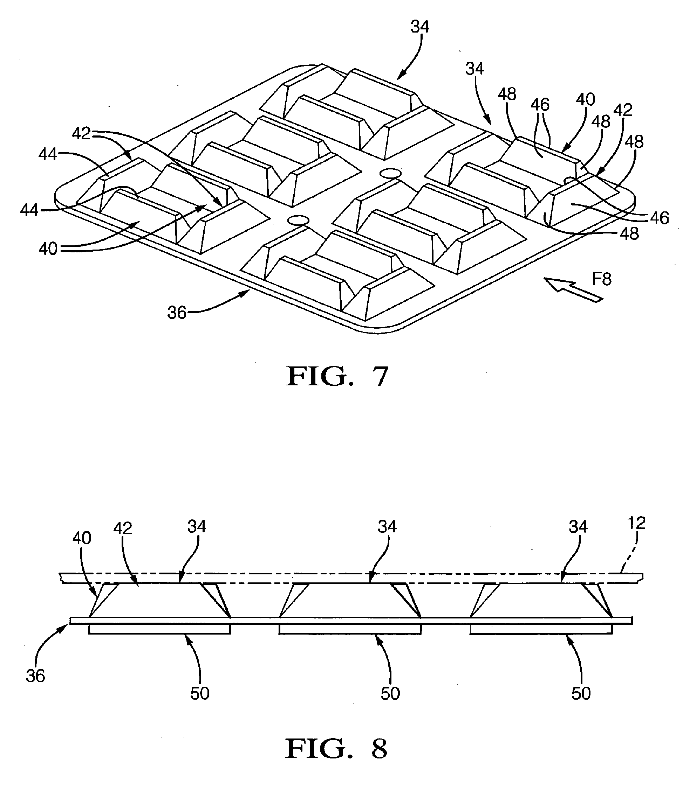

Avantageusement, pour obtenir une répartition de la pression sur la zone sensible 30 encore plus homogène, la surface de base 56 de chaque entretoise 34 peut être pourvue d'une plaquette 50 en matériau plus rigide que le matériau constituant l'entretoise 34. Une telle variante de réalisation est illustrée par la figure 8. La plaquette 50 est par exemple réalisée en matériau thermoplastique relativement rigide, par rapport au matériau élastomère constituant la plaque d'entretoise 36. La plaquette 50 peut être réalisée par surmoulage avec ladite plaque d'entretoise 36. Chaque plaquette 50 a de préférence une épaisseur axiale plus fine que l'épaisseur axiale des éléments en relief 40, 42 et elle s'étend globalement sur toute l'aire de la zone sensible 30 associée pour répartir la pression sur l'ensemble de la zone sensible 30.

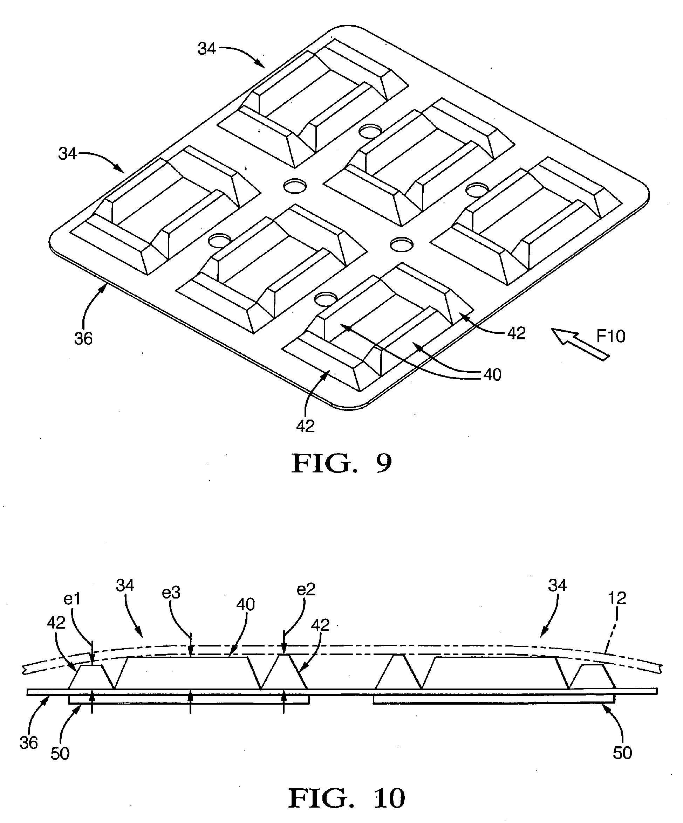

Selon un troisième mode de réalisation de l'invention, qui est représenté sur les figures 9 et 10, les plots intercalaires 40, 42 d'une entretoise 34 déterminée possèdent des épaisseurs axiales distinctes adaptées aux variations de hauteur du capot 12 par rapport au capteur 18. On décrira ici les principales différences entre le troisième et le deuxième mode de réalisation, sans détailler les caractéristiques communes.

Selon l'exemple de réalisation représenté sur les figures 9 et 10, les plots intercalaires 40, 42 ont globalement la même forme et le même type d'agencement sur la plaque d'entretoise 36 que dans le deuxième mode de réalisation des figures 6 à 8. Toutefois, en considérant par exemple l'entretoise 34 à gauche sur la figure 10, le plot intercalaire transversal 42 situé à proximité du bord périphérique de la plaque d'entretoise 36 possède une épaisseur axiale e1 inférieure à l'épaisseur axiale e2 du plot intercalaire transversal 42 situé du côté opposé audit bord périphérique. De plus, l'épaisseur axiale e3 des plots intercalaires longitudinaux 40 a une valeur intermédiaire entre les épaisseurs axiales e1, e2 des plots intercalaires transversaux 42 associés. Cette configuration permet ici de suivre la courbure du capot 12 qui délimite un espace axial avec le capteur 18 qui est plus faible à proximité du bord périphérique de la plaque d'entretoise 36 par rapport à la partie centrale de la plaque d'entretoise 36. Cette configuration peut aussi être adaptée dans le cas où, de par la structure du capot 12, la pression exercée au repos par le capot 12 sur les entretoises 34 est plus grande dans certaines zones, par exemple à proximité de points de fixation du capot 12 sur le support 14.

Ainsi, grâce à l'invention, il est possible d'obtenir une répartition sensiblement homogène de la force de précontrainte sur les capteurs 18, en tenant compte de la courbure du capot 12 vis-à-vis de la platine intermédiaire 38 et/ou des capteurs 18, en choisissant une épaisseur axiale adaptée pour chaque plots intercalaire 40, 42 en fonction de sa position sur la plaque d'entretoise 36. L'épaisseur axiale est ajustée ici en modifiant la hauteur de troncature de la forme pyramidale de chaque plot intercalaire 40, 42, sans modifier les dimensions de la forme pyramidale à sa base et sans modifier l'inclinaison de ses faces latérales 46, 48.

L'invention permet d'optimiser la répartition de la pression sur la zone sensible 30 en jouant, pour chaque entretoise 34, sur la répartition des plots intercalaires 40, 42 et sur leur hauteur.

Lorsque les zones de détection Z1, Z2, Z3, Z4, Z5, Z6 adjacentes correspondent à une portion de paroi amincie du capot 12, cette portion de paroi amincie offre une flexibilité supérieure aux autres zones du capot 12 qui facilite la détection des appuis tactile par les capteurs d'effort 18. Du fait de la répartition des points de fixation de la platine intermédiaire 38 sur le capot 12 sur le pourtour de la portion de paroi amincie et du fait de la flexibilité de cette portion de paroi amincie, la pression appliquée par le capot 12 sur les entretoises 34 tend à être plus élevée à la périphérie de la portion de paroi amincie par rapport au centre de la portion de paroi amincie. L'ajustement de la hauteur des plots intercalaires 40, 42 permet de compenser les différences de pression appliquées par le capot 12 sur les entretoises 34.

Le panneau de commande 10 a été décrit ici avec plusieurs boutons de commande B1, B2, B3, B4, B5, B6. Bien entendu, l'invention s'applique aux variantes de réalisation qui comporteraient un seul bouton de commande ou un nombre différent de boutons de commande.

## Revendications

1. Panneau de commande (10), notamment pour un véhicule automobile, comportant un capot (12) qui est monté sur un support (14) et qui est muni d'au moins une zone de détection (Z1, Z2, Z3, Z4, Z5, Z6) d'un appui tactile formant bouton de commande (B1, B2, B3, B4, B5, B6), dans lequel un capteur d'effort (18) comportant une zone sensible à la pression (30) est agencé entre le capot (12) et le support (14), à l'arrière de la zone de détection (Z1, Z2, Z3, Z4, Z5, Z6), de manière à détecter l'actionnement du bouton de commande (B1, B2, B3, B4, B5, B6) pour produire un signal électrique de commande lorsqu'un utilisateur exerce une force d'appui tactile déterminée sur la zone de détection (Z1, Z2, Z3, Z4, Z5, Z6), la force d'appui tactile étant transmise axialement (X1) vers la zone sensible (30) par l'intermédiaire d'une entretoise (34) en matériau compressible élastiquement qui est intercalée entre le capteur (18) et le capot (12), **caractérisé en ce que** l'entretoise (34) est montée comprimée axialement entre le capteur (18) et le capot (12) en l'absence d'appui tactile sur la zone de détection (Z1, Z2, Z3, Z4, Z5, Z6) de manière que le capteur (18) subisse une force de précontrainte au repos,
l'entretoise (34) comportant au moins un plot intercalaire pourvu d'une surface sommitale (44) transversale qui est en appui contre le capot (12) et d'une surface de base (45) transversale qui est en appui contre la zone sensible du capteur (18), la surface sommitale (44) ayant une aire inférieure à l'aire de la surface de base (45) de manière à minimiser la force de réaction exercée par l'entretoise (34) sur le capot (12) tout en assurant une répartition homogène de la force de précontrainte et de la force d'appui tactile sur la zone sensible (30) du capteur (18).

2. Panneau de commande (10) selon la revendication précédente, **caractérisé en ce que** la zone de détection (Z1, Z2, Z3, Z4, Z5, Z6) comporte une zone rétro-éclairée (P1, P2, P3, P4) qui est prévue pour être rétro-éclairée à travers l'entretoise (34), et **en ce que** l'entretoise (34) comporte un évidement central (58) pour le passage axial de la lumière vers la zone d'illumination (P1, P2, P3, P4).

3. Panneau de commande (10) selon la revendication précédente, **caractérisé en ce que** l'évidement central (58) correspond à un trou traversant aménagé dans l'entretoise (34).

4. Panneau de commande (10) selon la revendication 2 ou 3, **caractérisé en ce que** l'entretoise (34) comporte au moins un passage transversal (54) qui fait communiquer l'intérieur de l'évidement central (58) avec l'extérieur de l'entretoise (34).

5. Panneau de commande (10) selon l'une quelconque des revendications 2 à 4, **caractérisé en ce que** la zone sensible (30) a globalement une forme annulaire qui délimite un espace central (62) dont la forme correspond globalement à la forme de l'évidement central (58) en vue de faciliter le passage de la lumière à travers le capteur d'effort (18).

6. Panneau de commande (10) selon l'une quelconque des revendications précédentes, **caractérisé en ce que** l'entretoise (34) comporte un seul plot intercalaire (52) de forme globalement tronconique.

7. Panneau de commande (10) selon l'une quelconque des revendications 1 à 5, **caractérisé en ce que** l'entretoise (34) comporte plusieurs plots intercalaires (40, 42).

8. Panneau de commande (10) selon la revendication précédente, **caractérisé en ce que** les plots intercalaires (40, 42) sont répartis sensiblement parallèlement au contour extérieur de la zone sensible (30) du capteur (18).

9. Panneau de commande (10) selon la revendication précédente, **caractérisé en ce que** la zone sensible (30) a globalement un contour extérieur rectangulaire et **en ce que** l'entretoise (34) comporte, en vis-à-vis de la zone sensible (30), deux plots intercalaires (40) qui s'étendent dans la longueur de la zone sensible (30) et deux plots intercalaires (42) qui s'étendent dans la largeur de la zone sensible (30).

10. Panneau de commande (10) selon la revendication précédente, **caractérisé en ce que** chaque plot intercalaire (40, 42) a globalement la forme d'une pyramide tronquée et allongée comportant des faces latérales (46, 48) trapézoïdales et une surface sommitale (44) globalement rectangulaire.

11. Panneau de commande (10) selon l'une quelconque des revendications 7 à 10, **caractérisé en ce que** les plots intercalaires (40, 42) associés à une zone sensible (30) déterminée possèdent des épaisseurs axiales (e1, e2, e3) distinctes adaptées aux variations de hauteur du capot (12) par rapport au capteur (18).

12. Panneau de commande (10) selon l'une quelconque des revendications précédentes, **caractérisé en ce que** l'entretoise (34) et le capteur (18) sont montés comprimés axialement entre le capot (12) et une platine intermédiaire (38) qui est fixée directement sur le capot (12), indépendamment du support (14).

13. Panneau de commande (10) selon l'une quelconque des revendications précédentes, **caractérisé en ce que** l'entretoise (34) est réalisée venue de matière dans une plaque d'entretoise (36) transversale et **en ce que** la plaque d'entretoise (36) est pourvue de moyens de positionnement (66, 68) qui assurent le centrage de l'entretoise (34) vis-à-vis de la zone sensible (30) et vis-à-vis de la zone de détection (Z1, Z2, Z3, Z4, Z5, Z6) associées.

14. Panneau de commande (10) selon la revendication précédente, **caractérisé en ce que** la plaque d'entretoise (36) comporte plusieurs entretoises (34) qui sont associées respectivement à plusieurs zones de détection (Z1, Z2, Z3, Z4, Z5, Z6).

15. Panneau de commande (10) selon l'une quelconque des revendications précédentes, **caractérisé en ce qu'**une plaquette (50) en matériau plus rigide que le matériau constituant l'entretoise (34) est intercalée entre l'entretoise (34) et la zone sensible (30) du capteur (18) en vue de contribuer à une répartition homogène de la force de précontrainte et de la force d'appui tactile sur la zone sensible (30) du capteur (18).

## Patentansprüche

1. Bedienfeld (10), insbesondere für ein Kraftfahrzeug, enthaltend eine Abdeckung (12), die an einem Träger (14) montiert ist und mit zumindest einem Erfassungsbereich (Z1, Z2, Z3, Z4, Z5, Z6) zum Erfassen einer physischen Berührung ausgestattet ist, der eine Steuertaste (B1, B2, B3, B4, B5, B6) darstellt, wobei ein Kraftsensor (18) mit einem druckempfindlichen Bereich (30) zwischen der Abdeckung (12) und dem Träger (14) auf der Hinterseite des Erfassungsbereichs (Z1, Z2, Z3, Z4, Z5, Z6) so angeordnet ist, dass die Betätigung der Steuertaste (B1, B2, B3, B4, B5, B6) erfasst wird, um ein elektrisches Steuersignal dann zu erzeugen, wenn ein Benutzer eine bestimmte Berührungskraft auf den Erfassungsbereich (Z1, Z2, Z3, Z4, Z5, Z6) ausübt, wobei die Berührungskraft axial (X1) auf den empfindlichen Bereich (30) über eine Verstrebung (34) aus elastisch zusammendrückbarem Material übertragen wird, die zwischen dem Sensor (18) und der Abdeckung (12) eingesetzt ist, **dadurch gekennzeichnet, dass** bei ausbleibender physischer Berührung des Erfassungsbereichs (Z1, Z2, Z3, Z4, Z5, Z6) die Verstrebung (34) zwischen dem Sensor (18) und der Abdeckung (12) axial zusammengedrückt angebracht ist, so dass der Sensor (18) im Ruhezustand einer Vorspannkraft ausgesetzt ist,
wobei die Verstrebung (34) zumindest ein Zwischenstück aufweist, das mit einer quer verlaufenden Kammfläche (44) versehen ist, die in Anlage an der Abdeckung (12) ist, sowie mit einer quer verlaufenden Grundfläche (45), die in Anlage an den empfindlichen Bereich des Sensors (18) ist, wobei die Kammfläche (44) einen kleineren Flächeninhalt als die Grundfläche (45) aufweist, so dass die von der Verstrebung (34) auf die Abdeckung (12) ausgeübte Reaktionskraft minimiert wird und dabei eine gleichmäßige Verteilung der Vorspannkraft und der Berührungskraft auf den empfindlichen Bereich (30) des Sensors (18) sichergestellt wird.

2. Bedienfeld (10) nach dem vorangehenden Anspruch, **dadurch gekennzeichnet, dass** der Erfassungsbereich (Z1, Z2, Z3, Z4, Z5, Z6) einen hinterleuchteten Bereich (P1, P2, P3, P4) aufweist, der dazu vorgesehen ist, durch die Verstrebung (34) hindurch hinterleuchtet zu werden, und dass die Verstrebung (34) eine mittige Ausnehmung (58) für den axialen Durchtritt von Licht zum Leuchtbereich (P1, P2, P3, P4) aufweist.

3. Bedienfeld (10) nach dem vorangehenden Anspruch, **dadurch gekennzeichnet, dass** die mittige Ausnehmung (58) einem quer verlaufenden Loch entspricht, das in die Verstrebung (34) eingebracht ist.

4. Bedienfeld (10) nach Anspruch 2 oder 3, **dadurch gekennzeichnet, dass** die Verstrebung (34) zumindest einen quer verlaufenden Durchgang (54) aufweist, der den Innenraum der mittigen Ausnehmung (58) mit dem Außenraum der Verstrebung (34) verbindet.

5. Bedienfeld (10) nach einem der Ansprüche 2 bis 4, **dadurch gekennzeichnet, dass** der empfindliche Bereich (30) insgesamt eine Ringform aufweist, welche einen Mittelraum (62) eingrenzt, dessen Form insgesamt der Form der mittigen Ausnehmung (58) entspricht, um den Durchtritt von Licht durch den Kraftsensor (18) hindurch zu erleichtern.

6. Bedienfeld (10) nach einem der vorangehenden Ansprüche, **dadurch gekennzeichnet, dass** die Verstrebung (34) ein einziges Zwischenstück (52) in Kegelstumpfform aufweist.

7. Bedienfeld (10) nach einem der Ansprüche 1 bis 5, **dadurch gekennzeichnet, dass** die Verstrebung (34) mehrere Zwischenstücke (40, 42) aufweist.

8. Bedienfeld (10) nach dem vorangehenden Anspruch, **dadurch gekennzeichnet, dass** die Zwischenstücke (40, 42) im Wesentlichen parallel zur Außenkontur des empfindlichen Bereichs (30) des Sensors (18) verteilt sind.

9. Bedienfeld (10) nach dem vorangehenden Anspruch, **dadurch gekennzeichnet, dass** der empfindliche Bereich (30) insgesamt eine rechteckförmige Außenkontur aufweist und dass die Verstrebung (34) dem empfindlichen Bereich (30) gegenüberliegend zwei Zwischenstücke (40) aufweist, die sich der Länge des empfindlichen Bereichs (30) nach erstrecken, sowie zwei Zwischenstücke (42), die sich der Breite des empfindlichen Bereichs (30) nach erstrecken.

10. Bedienfeld (10) nach dem vorangehenden Anspruch, **dadurch gekennzeichnet, dass** jedes Zwischenstück (40, 42) insgesamt in Form eines länglichen Pyramidenstumpfs vorliegt, der trapezförmige Seitenflächen (46, 48) und eine rechteckförmige Kammfläche (44) aufweist.

11. Bedienfeld (10) nach einem der Ansprüche 7 bis 10, **dadurch gekennzeichnet, dass** die einem bestimmten empfindlichen Bereich (30) zugeordneten Zwischenstücke (40, 42) unterschiedliche axiale Stärken (e1, e2, e3) haben, die den Höhenschwankungen der Abdeckung (12) bezüglich des Sensors (18) angepasst sind.

12. Bedienfeld (10) nach einem der vorangehenden Ansprüche, **dadurch gekennzeichnet, dass** die Verstrebung (34) und der Sensor (18) zwischen der Abdeckung (12) und einer Zwischenplatte (38), die unabhängig vom Träger (14) direkt an der Abdeckung (12) befestigt ist, axial zusammengedrückt angebracht sind.

13. Bedienfeld (10) nach einem der vorangehenden Ansprüche, **dadurch gekennzeichnet, dass** die Verstrebung (34) stoffschlüssig in einer quer verlaufenden Verstrebungsplatte (36) ausgebildet ist und dass die Verstrebungsplatte (36) mit Positioniermitteln (66, 68) versehen ist, die das Zentrieren der Verstrebung (34) gegenüber dem zugeordneten empfindlichen Bereich (30) und gegenüber dem zugeordneten Erfassungsbereich (Z1, Z2, Z3, Z4, Z5, Z6) sicherstellen.

14. Bedienfeld (10) nach dem vorangehenden Anspruch, **dadurch gekennzeichnet, dass** die Verstrebungsplatte (36) mehrere Verstrebungen (34) aufweist, die mehreren jeweiligen Erfassungsbereichen (Z1, Z2, Z3, Z4, Z5, Z6) zugeordnet sind.

15. Bedienfeld (10) nach einem der vorangehenden Ansprüche, **dadurch gekennzeichnet, dass** eine Scheibe (50) aus einem steiferen Material als das die Verstrebung (34) bildende Material zwischen der Verstrebung (34) und dem empfindlichen Bereich (30) des Sensors (18) eingesetzt ist, um zu einer gleichmäßigen Verteilung der Vorspannkraft und der Berührungskraft auf dem empfindlichen Bereich (30) des Sensors (18) beizutragen.

## Claims

1. Control panel (10), in particular for an automobile vehicle, comprising a cover (12) which is mounted on a support (14) and which is provided with at least one zone (Z1, Z2, Z3, Z4, Z5, Z6) for the detection of tactile pressure forming a control button (B1, B2, B3, B4, B5, B6), in which a load sensor (18) comprising a pressure-sensitive zone (30) is disposed between the cover (12) and the support (14), to the rear of the detection zone (Z1, Z2, Z3, Z4, Z5, Z6), so as to detect actuation of the control button (B1, B2, B3, B4, B5, B6) in order to produce an electrical control signal when a user exerts a given tactile pressure on the detection zone (Z1, Z2, Z3, Z4, Z5, Z6), the tactile pressure being transmitted axially (X1) towards the sensitive zone (30) by means of a spacer (34) made of elastically compressible material which is inserted between the sensor (18) and the cover (12), the spacer (34) being mounted compressed axially between the sensor (18) and the cover (12) in the absence of tactile pressure on the detection zone (Z1, Z2, Z3, Z4, Z5, Z6) so that the sensor (18) undergoes a pre-stressing force at rest,
**characterised in that** the spacer (34) comprises at least one separating stud provided with a transverse top surface (44) which presses against the cover (12) and a transverse bottom surface (45) which presses against the sensitive zone of the sensor (18), the top surface (44) having an area smaller than the area of the bottom surface (45) so as to minimise the reaction force exerted by the spacer (34) on the cover (12) while ensuring uniform distribution of the pre-stressing force and the tactile pressure on the sensitive zone (30) of the sensor (18).

2. Control panel (10) according to the preceding claim, **characterised in that** the detection zone (Z1, Z2, Z3, Z4, Z5, Z6) comprises a backlit zone (P1, P2, P3, P4) which is provided to be backlit through the spacer (34), and **in that** the spacer (34) comprises a central recess (58) for axial passage of the light towards the lighting zone (P1, P2, P3, P4).

3. Control panel (10) according to the preceding claim, **characterised in that** the central recess (58) corresponds to a through-hole formed in the spacer (34).

4. Control panel (10) according to claim 2 or 3, **characterised in that** the spacer (34) comprises at least one transverse passage (54) which causes the interior of the central recess (58) to communicate with the exterior of the spacer (34).

5. Control panel (10) according to any of claims 2 to 4, **characterised in that** the sensitive zone (30) has, overall, an annular shape which defines a central space (62) of which the shape corresponds overall to the shape of the central recess (58) in order to facilitate passage of the light through the load sensor (18).

6. Control panel (10) according to any of the preceding claims, **characterised in that** the spacer (34) comprises a single separating stud (52) of generally frustoconical shape.

7. Control panel (10) according to any of claims 1 to 5, **characterised in that** the spacer (34) comprises several separating studs (40, 42).

8. Control panel (10) according to the preceding claim, **characterised in that** the separating studs (40, 42) are distributed substantially parallel to the outer contour of the sensitive zone (30) of the sensor (18).

9. Control panel (10) according to the preceding claim, **characterised in that** the sensitive zone (30) has, overall, a rectangular outer contour and **in that** the spacer (34) comprises, opposite the sensitive zone (30), two separating studs (40) which extend along the length of the sensitive zone (30) and two separating studs (42) which extend across the width of the sensitive zone (30).

10. Control panel (10) according to the preceding claim, **characterised in that** each separating stud (40, 42) has, overall, the shape of a truncated, elongate pyramid comprising trapezoidal side faces (46, 48) and a generally rectangular top surface (44).

11. Control panel (10) according to any of claims 7 to 10, **characterised in that** the separating studs (40, 42) associated with a given sensitive zone (30) have different axial thicknesses (e1, e2, e3) adapted to the variations in height of the cover (12) relative to the sensor (18).

12. Control panel (10) according to any of the preceding claims, **characterised in that** the spacer (34) and the sensor (18) are mounted compressed axially between the cover (12) and an intermediate board (38) which is fixed directly to the cover (12), independently of the support (14).

13. Control panel (10) according to any of the preceding claims, **characterised in that** the spacer (34) is formed integrally in a transverse spacer plate (36) and **in that** the spacer plate (36) is provided with positioning means (66, 68) which ensure centring of the spacer (34) relative to the associated sensitive zone (30) and relative to the associated detection zone (Z1, Z2, Z3, Z4, Z5, Z6).

14. Control panel (10) according to the preceding claim, **characterised in that** the spacer plate (36) comprises several spacers (34) which are respectively associated with several detection zones (Z1, Z2, Z3, Z4, Z5, Z6).

15. Control panel (10) according to any of the preceding claims, **characterised in that** a pad (50) made of more rigid material than the material constituting the spacer (34) is inserted between the spacer (34) and the sensitive zone (30) of the sensor (18) in order to contribute to uniform distribution of the pre-stressing force and the tactile pressure on the sensitive zone (30) of the sensor (18).
